# EUROPEAN PATENT APPLICATION

(11) **EP 0 537 791 A1**
(43) Date of publication of application: **21.04.1993**
(21) Application number: 92117818.2
(22) Date of filing: 19.10.1992
(51) Int. Cl.: H01L 27/115, H01L 27/108, G11C 11/22

(54) **Semiconductor memory**

(30) Priority: 18.10.1991 JP 271158/91
(71) Applicant: RAMTRON INTERNATIONAL CORPORATION, Colorado Springs Colorado 80918 (US)
(72) Inventor: Fujisawa, Akira, Suwa-shi, Nagano-ken 392 (JP)
(74) Representative: Bosotti, Luciano

(57) **Abstract**

In a semiconductor memory having a capacitance element including a ferroelectric layer (107), the ferroelectric layer as a basic layer is buried in a groove formed in the surface of a silicon substrate (101) where a high-density diffusion layer (104) of a MIS-type transistor is located.

## Description

The present invention relates to a semiconductor memory, and more specifically, is directed to a nonvolatile semiconductor memory having a ferroelectric layer capable of being electrically polarized as a basic layer.

Since the early 1950's, there has been developed a storage device having a layer capable of being electrically polarized.

In order to store information in the device, a voltage is applied to corresponding upper and lower electrodes (corresponding to row and column addresses in the case of an ordinary semiconductor), thereby polarizing a region located at the intersection between these electrodes. Moreover, for the execution of the read-out process, for example, a specified memory region may be piezoelectrically or pyroelectrically activated. Alternatively, a destructive read is also permissible. In addition, the information can be permanently kept without further external power supply by virtue of the residual polarization exhibited by the ferroelectric materials. However, it has been found that a peripheral device, such as an electronic control device required for writing or reading information, is relatively complicated and needs a large access time. Accordingly, it was disclosed in the late 1970's that a ferroelectric storage element can be integrated directly with respect to a control module or in cooperation therewith (R. C. Cook, United States Patent No. 4,149,302 (1979)).

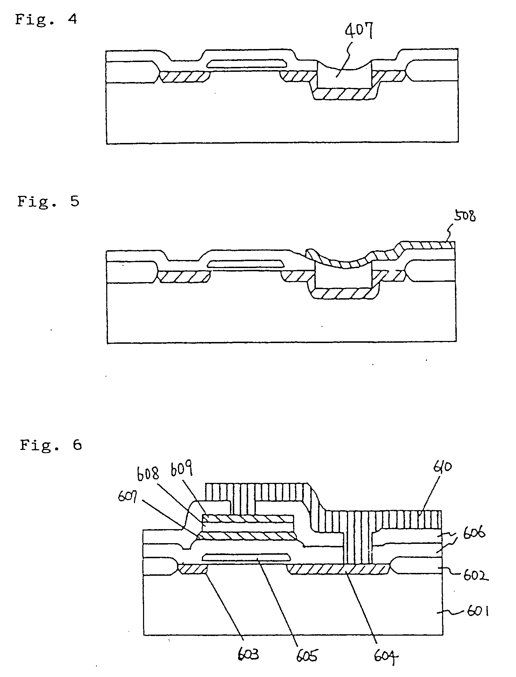

Recently, in IEDM '87, pp. 850 to 851, there was disclosed a storage device having a structure where a MIS-type semiconductor device is laminated, as shown in Fig. 6 of the present application. In Fig. 6, 601 denotes a P-type silicon substrate, 602 denotes a LOCOS oxide film for element isolation, and 603 and 604 designate N-type diffusion layers acting as a source and a drain, respectively. Reference numeral 605 signifies a gate electrode, and 606 designates an interlayer insulation film. Reference numeral 608 indicates a ferroelectric film, located between the lower electrode 607 and the upper electrode 609 so as to constitute a capacitor. Reference numeral 610 denotes an aluminum wiring (or interconnection) for the connection of the capacitor to the MIS transistor.

The conventional memory cell shown in Fig. 6 has a structure where the capacitance element is laminated over the MIS-type semiconductor device, which needs wiring for connecting the electrodes of the capacitance element with the high-density diffusion layer, i.e. the source and drain of the MIS-type semiconductor device. This adversely causes an increase in the area occupied by the element. In addition, a substantial unevenness of the surface may reduce the coverage of the aluminum wiring layer, thus disadvantageously resulting in a reduction in the yield and long term reliability.

It is therefore an object of the present invention to overcome the above problems and provide a semiconductor device having a capacitance element which includes a ferroelectric layer as a basic layer. It is a further object of the device to be capable of being further integrated due to a reduction in the memory cell area and improvement in the flatness of the element so as to ensure a high yield and high quality.

In a semiconductor device of the present invention having a capacitance element including a ferroelectric layer as a basic layer, the ferroelectric layer is buried in a groove formed in the surface of a silicon substrate where a high-density diffusion layer of a MIS-transistor is located.

In describing the embodiments, reference is made to the accompanying drawings.
Fig. 1 shows a sectional view of a semiconductor device in accordance with the present invention;
Fig. 2 shows a sectional view of a step in a process for the manufacture of the semiconductor device of the present invention;
Fig. 3 illustrates a sectional view of a step in a process for manufacturing the semiconductor device of the present invention;
Fig. 4 illustrates a sectional view of a step in a process for manufacturing the semiconductor device of the present invention;
Fig. 5 depicts a sectional view of a step in a process for manufacturing the semiconductor device of the present invention; and
Fig. 6 depicts a sectional view of a conventional semiconductor memory having a basic layer comprising a ferroelectric layer which is capable of being electrically polarized.

The present invention will be hereinafter described in more detail with reference to the accompanying drawings and presently preferred exemplary embodiments.

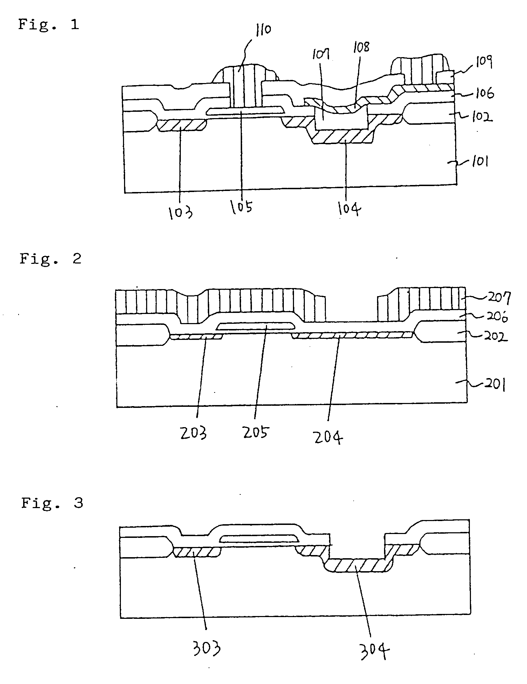

Fig. 1 is a sectional view of a semiconductor device in accordance with the present invention. In Fig. 1, 101 denotes a P-type silicon substrate, 102 denotes a LOCOS (local oxidation of silicon) oxide film for element isolation, and 103 and 104 denote N-type diffusion layers acting as a source and a drain region, respectively.

Reference numeral 105 designates a gate electrode, and 106 designates an interlayer insulation film. Reference numeral 107 signifies a ferroelectric thin film embedded in a groove formed in the surface of the silicon substrate. As a result, the surface of the device prior to the formation of aluminum wiring (or interconnection) is less uneven than the surface in conventional devices. Reference numeral 108 represents an electrode constituting a part of a capacitor and comprising, for example, a platinum thin film. Another electrode constituting a part of the capacitor is designated by reference numeral 104 and also serves as a drain for the MIS (metal-insulator semiconductor) transistor. It is therefore unnecessary to provide a wiring, such as 610 shown in Fig. 6, for connecting the capacitor to the MIS transistor. Reference numeral 109 indicates an interlayer insulation film, and 110 a wiring layer made of, for example, aluminum. As a result of the structure of the present invention, there is an increase in the freedom of the wiring layout as compared to the prior art. Furthermore, less wiring area in total contributes to a better structure.

Figs. 2 to 5 are sectional views of steps in a process for the manufacture of the semiconductor device of the present invention as shown in Fig. 1. Preferred embodiments thereof will be hereinbelow described.
(1) As illustrated in Fig. 2, an oxide film 202 for element isolation, a gate electrode 205, and an interlayer insulation film 206 are first formed on a P-type silicon substrate 201. A photoresist 207 is then applied, and a portion of the photoresist on a region where a groove in the silicon substrate is to be formed is removed by using an exposure technique. Reference numerals 203 and 204 indicate regions intended for a source and a drain, respectively. The regions having been subjected to an ion implantation of phosphorus, for example.
(2) Subsequently, the interlayer insulation film 206 and the silicon substrate lying in the predetermined region are removed by a dry etching technique, for example. Then the region cleared of the silicon substrate again undergoes a phosphorus ion implantation to form a portion corresponding to a lower electrode of the capacitor. Afterward, the photoresist 207 is removed, and the ion-implanted phosphorus is diffused by heat-treating to obtain the structure shown in Fig. 3. Reference numerals 303 and 304 are impurity diffusion layers intended as a source and a drain region, respectively.
(3) Subsequently, the structure is subject to a spin coating at 3000 to 6000 rpm by the use of a coating agent of metallic alcoholate including ingredients constituting the ferroelectric, Afterward, the coating agent, except in the capacitor section, is removed by means of photoetching. The substrate then undergoes a heat treatment in an atmosphere containing, for example, oxygen at 600°C for an hour, thereby sintering the agent to form a portion designated by reference numeral 407 in Fig. 4.
(4) Platinum for the upper electrode is further deposited in the substrate by means of, for example, 1000 Å sputtering and photoetching, to consequently form the portion designated by reference numeral 508 in Fig. 5.

After the formation of the interlayer insulation film 109 and the subsequent formation of a contact hole as shown in Fig. 1, the wiring layer 110 is formed, of aluminum for example, at a thickness of for example 5000 Å, with the required wiring pattern. Thus, the structure of the present invention is obtained.

According to the present invention as described hereinabove, the ferroelectric thin film is buried in the groove provided in the surface of the silicon substrate where a high-density diffusion layer of the MIS-type transistor is located. The result is that the necessity of the wiring for connecting the transistor to a capacitance element is eliminated which reduces the area of a memory cell and the flatness of the device. Hence, the coverage of the aluminum wiring layer is improved, thus making it possible to manufacture at a higher yield semiconductor devices having a capacitance element which comprises a high-quality ferroelectric layer as a basic layer.

## Claims

1. A semiconductor memory having a capacitance element including a ferroelectric layer (107), characterised in that it comprises a groove formed in the surface of a silicon substrate (101) where a high density diffusion layer (104) of a MIS-type transistor is located, said ferroelectric layer (107) being buried in said groove.

2. A semiconductor memory characterised in that it comprises:
a substrate having source and drain regions located therein;
a ferroelectric material (107) located directly over and in contact with said drain region; and
an electrode located over said ferroelectric material (107).

3. The memory of Claim 2, characterised in that said drain region and said ferroelectric material (107) are located in a groove in said substrate.

4. The memory of Claim 2, characterised in that said drain region is coupled to a transistor.

5. The memory of Claim 4, characterised in that it further comprises a wiring layer coupled to said transistor.

6. The memory of Claim 2, characterised in that said electrode is comprised of platinum.

7. The memory of Claim 5, characterised in that said wiring layer is comprised of aluminum.

8. A method for forming a semiconductor device, characterised in that it comprises the steps of:
establishing a substrate;
forming a source region and a drain region in said substrate;
estabilishing a ferroelectric material (107) directly over and in contact with said drain region; and
establishing an electrode over said ferroelectric material.

9. The method of Claim 8, characterised in that it further comprises the step of establishing a groove in said substrate and forming said drain region and said ferroelectric material in said groove.

10. The method of Claim 8, characterised in that said drain region is formed by two ion implantations followed by heat treatment.

11. The method of Claim 8, characterised in that it further comprises forming a transistor over said substrate and coupled to said drain region.

12. The method of Claim 11, characterised in that it further comprises forming a wiring layer coupled to said transistor.
